# EUROPEAN PATENT APPLICATION

(11) **EP 4 603 220 A1**
(43) Date of publication of application: **20.08.2025**
(21) Application number: 23891463.4
(22) Date of filing: 09.11.2023
(51) Int. Cl.: B23K 26/064, B23K 26/36

(54) **LASER PROCESSING METHOD, SUBSTRATE MANUFACTURING METHOD, LASER PROCESSING DEVICE, SUBSTRATE, AND SEMICONDUCTOR PACKAGE SUBSTRATE**

(30) Priority: 17.11.2022 WO PCT/JP2022/042754
(71) Applicant: Shin-etsu Engineering Co., Ltd., Tokyo 101-0054 (JP)
(72) Inventor: OHTANI, Yoshikazu, Annaka-shi, Gunma 379-0127 (JP); YAMAOKA, Hiroshi, Yokohamashi, Kanagawa 234-0053 (JP)
(74) Representative: Meissner Bolte Partnerschaft mbB
(86) International application number: PCT/JP2023/040459
(87) International publication number: WO 2024/106313

(57) **Abstract**

The present invention provides a laser processing method for forming a recess and/or a through hole on an object to be processed using laser, wherein processing is performed with an irradiation shape in which intensity distribution of the laser on a surface to be processed of the object to be processed is set such that an intensity of an outer portion is larger than an intensity of an inner portion in the intensity distribution. This can provide a laser processing method that can inhibit a taper shape of the recess and/or through hole to be formed even when the recess and/or the through hole is formed with high resolution, and can consequently form a highly fine and complex pattern.

## Description

### TECHNICAL FIELD

The present invention relates to a laser processing method, a method for producing a substrate, a laser processing apparatus, a substrate, and a semiconductor package substrate.

### BACKGROUND ART

The trend of semiconductor package substrates has changed from "More Than More" to System on a Chip (SoC) in which a system is mounted on one chip, and the development is actively progressing along this trend.

The semiconductor package substrate has had complex and highly dense configuration, and an apparatus using excimer laser has been applied for producing its base substrate.

For example, Patent Document 1 describes a laser processing method of processing a shape of an object to be processed until a predetermined depth position by using laser light, wherein a laser power of the laser light and a relative motion speed between the object to be processed and the laser light are increased so that an energy per unit length of the laser light optimally set according to the object to be processed is within an energy range so as not to penetrate the object to be processed even when the laser power increases due to power deviation with an oscillator of the laser light, and the number of irradiation times required for the laser processing is reduced.

Patent Document 2 describes a laser processing method of sequentially irradiating an excavated region of an object to be processed with laser light having a beam cross section smaller than the excavated region to process the excavated region, the method including: a first processing step of sequentially irradiating an entirety of the excavated region with laser light having a beam cross section of a first shape and having a first irradiation region corresponding to the beam cross section of the first shape on the object to be processed; and a second processing step of sequentially irradiating the excavation region with laser light having a beam cross section of a second shape smaller than the first shape and having a second irradiation region corresponding to the beam cross section of the second shape on the object to be processed, wherein, in the first processing step, irradiation with the laser light having the first irradiation region is sequentially performed so as to form an overlapped region where parts of the first irradiation regions are overlapped with each other, and in the second processing step, irradiation with the laser light having the second irradiation region is sequentially performed so as to contain the second irradiation region in a region other than the overlapped region in the excavated region.

Non Patent Document 1 introduces formation of high-quality and high-aspect Si through holes using Bessel beam.

### CITATION LIST

### PATENT LITERATURE

Patent Document 1: JP 2009-22978 A
Patent Document 2: WO 2013/094025 A1

### NON PATENT LITERATURE

Non Patent Document 1: Koji Sugioka, "Formation of High-Quality and High-Aspect Si Through Holes with Optimized Ultrashort-Pulse Bessel Beam", FORM TECH REVIEW 2016, VOL. 26.

### SUMMARY OF INVENTION

### TECHNICAL PROBLEM

There has been conventionally a problem that a recess formed by laser processing with higher resolution has a smaller width of a bottom of the recess compared with a width of an opening of the recess in an initial processed surface, namely a taper shape. There has been also conventionally a problem that a through hole formed with higher resolution has a smaller width of an opening on a lower end of the through hole compared with a width of an upper end of the through hole, namely a taper shape. The formation of the taper recess and/or through hole as above is inconvenient for forming a highly fine and complex pattern (for example, a circuit pattern).

Particularly, metal wiring may be embedded in the processed recess in application of a substrate for a semiconductor package, and a highly fine pattern increases wiring resistance. To prevent this increase in the wiring resistance, deep processing with a large width to the bottom is demanded. Performing such processing can produce a substrate for a semiconductor package having low wiring resistance and high quality.

The present invention has been made to solve the above problems. An object of the present invention is to provide: a laser processing method that can inhibit a taper shape of a recess and/or through hole to be formed, and can consequently form a highly fine and complex pattern even when the recess and/or the through hole is formed with high resolution; a method for producing a substrate that can produce a substrate having a highly fine and complex pattern; a laser processing apparatus that can inhibit a taper shape of a recess and/or a through hole to be formed to provide a high-quality semiconductor package substrate having low wiring resistance, and consequently form a highly fine and complex pattern even when the recess and/or the through hole is formed with high resolution; a substrate that can achieve a highly fine and complex wiring pattern; a substrate that can achieve a VIA electrode pattern with inhibited tapering from a front face to a back face; a semiconductor package substrate having a highly fine and complex metal wiring pattern; and a semiconductor package substrate having a VIA electrode pattern with inhibited tapering from a front face to a back face.

### SOLUTION TO PROBLEM

To solve the above problem, the present invention provides a laser processing method for forming a recess and/or a through hole on an object to be processed using laser, wherein
processing is performed with an irradiation shape in which intensity distribution of the laser on a surface to be processed of the object to be processed is set such that an intensity of an outer portion is larger than an intensity of an inner portion in the intensity distribution.

The laser processing method as above can inhibit reduction in the width of the bottom of the recess compared with the width of the opening of the recess on the initial processed surface even when the recess is formed with high resolution. In addition, the laser processing method as above can inhibit reduction in the width of the opening on the lower end of the through hole compared with the width of the upper end of the through hole even when the through hole is formed with high resolution. That is, the laser processing method of the present invention can inhibit a taper shape of the recess and/or through hole to be formed even when the recess and/or the through hole is formed with high resolution, and can consequently form the highly fine and complex pattern.

For example, the processing may be performed while changing the shape of the intensity distribution of the laser on the surface to be processed of the object to be processed as the processing proceeds in a depth direction of the object to be processed.

As above, the intensity distribution of the laser may be changed as the processing proceeds in the depth direction of the object to be processed. Note that, in the present invention, processing is performed with the irradiation shape in which the intensity of the outer portion is larger than the intensity of the inner portion in the intensity distribution of the laser on at least one surface to be processed of the object to be processed, and the intensity distribution of the laser is not necessarily changed continuously.

In this case, processing may be performed while changing the shape of the intensity distribution of the laser so that the intensity of the outer portion is larger than the intensity of the inner portion in the intensity distribution of the laser as the processing proceeds in the depth direction of the object to be processed.

The processing as above can more certainly inhibit the taper shape of the recess and/or through hole to be formed, and can consequently form the highly fine and complex pattern more certainly.

For example, processing may be performed while changing the shape of the intensity distribution of the laser so that the intensity of the outer portion is larger than the intensity of the inner portion in the intensity distribution of the laser as the processing proceeds in the depth direction of the object to be processed by passing laser having intensity distribution in which a laser intensity at a center is largest and a laser intensity in a base is small through a prism.

A means for setting the irradiation shape of the laser so that the intensity of the outer portion is larger than the intensity of the inner portion in the intensity distribution is not particularly limited. For example, the irradiation shape of the laser may be changed by passing the laser through the prism.

In this case, a component including a roof prism or a conical prism may be used as the prism, for example.

For example, the irradiation shape of the laser may be set to be the irradiation shape in which the intensity of the outer portion is larger than the intensity of the inner portion in the intensity distribution by using the prism containing the roof prism or the conical prism.

In addition, the present invention provides a laser processing method for forming a recess and/or a through hole on an object to be processed using laser, wherein an optical system is used, the optical system is configured to shape an irradiation shape of the laser in which an intensity of an outer portion is larger than an intensity of an inner portion in intensity distribution of the laser into a top-hat-shaped irradiation shape.

By processing the object to be processed with laser using such optical system, processing with the irradiation shape of the laser, in which the intensity of the outer portion is larger than the intensity of the inner portion in at least a part distanced from the surface in the object to be processed, can be achieved. The laser processing method as above can inhibit reduction in the width of the bottom of the recess compared with the width of the opening of the recess in the initial processed surface even when the recess is formed with high resolution. In addition, the laser processing method as above can inhibit reduction in the width of the opening on the lower end of the through hole compared with the width of the upper end of the through hole even when the through hole is formed with high resolution. That is, the laser processing method of the present invention can inhibit the taper shape of the recess and/or through hole to be formed even when the recess and/or the through hole is formed with high resolution, and can consequently form the highly fine and complex pattern.

For example, an initial surface to be processed of the object to be processed may be processed with laser having the top-hat-shaped irradiation shape, and
at least a part of the object to be processed except for the initial surface to be processed may be processed with laser having the irradiation shape in which the intensity of the outer portion is larger than the intensity of the inner portion.

As above, the initial surface to be processed of the object to be processed may be processed with laser having the top-hat-shaped irradiation shape.

For example, a substrate for a semiconductor package may be processed as the object to be processed to form a recess and/or a through hole on the substrate for a semiconductor package.

The object to be processed is not particularly limited, and the semiconductor package substrate may be used as the object to be processed, for example.

Processing the semiconductor package substrate includes a processing pattern in which the through hole and the recess, for example, VIA processing and groove processing are mixed. In this case, the processing can be performed in the single step by the method of the present invention without separating steps for the VIA processing and the groove processing from each other. The semiconductor package substrate has had higher density, and a laser drilling method, conventionally performed in the VIA processing, increases the processing time due to increased number of processing holes involved with the higher density. In contrast, the present method does not increase the processing time due to the increased number of processing holes and the finer pattern.

For example, the laser may be oscillated by using an excimer laser oscillator.

The laser light source is not particularly limited, and the excimer laser oscillator may be used, for example. Use of the excimer laser can efficiently process an object to be processed composed of an organic material, such as, for example, an ABF substrate, to enable processing with high productivity. In addition, since the excimer laser has low coherence, use of the excimer laser enables extremely uniform beam formation.

The object to be processed may be irradiated with the laser through a photomask.

The laser processing of the present invention may be performed by using the photomask.

Processing may be performed while relatively scanning the laser relative to the surface to be processed.

The laser processing of the present invention may be scanning processing.

For example, ablation processing may be performed.

According to the laser processing method of the present invention, the ablation processing may be performed, for example.

For example, the recess and/or the through hole having a width of 20 µm or less may be formed.

According to the laser processing method of the present invention, a highly fine pattern having the recess and/or the through hole having a width of 20 µm or less can be formed.

For example, the recess and/or the through hole having a depth of 20 µm or less may be formed.

According to the laser processing method of the present invention, a highly fine pattern having the recess and/or the through hole having a depth of 20 µm or less can be formed.

As the recess and/or the through hole, a recess and/or a through hole in which a ratio of a height of a processed portion relative to a width of a bottom of the recess or to a width of an opening on a lower end of the through hole is 1.0 or more may be formed.

According to the laser processing method of the present invention, the recess and/or the through hole having such a high aspect ratio can be formed.

The recess may be formed in which a width of a bottom of the recess is 70% or more of an opening width of the recess on an initial processed surface of the object to be processed, and/or
the through hole may be formed in which a width of an opening on a lower end of the through hole is 70% or more of a width of an opening on an upper end of the through hole on the initial processed surface of the object to be processed.

According to the laser processing method of the present invention, for example, the recess in which a width of a bottom of the recess is 70% or more of an opening width of the recess on an initial processed surface of the object to be processed, and/or the through hole in which a width of an opening on a lower end of the through hole is 70% or more of a width of an opening on an upper end of the through hole on the initial processed surface of the object to be processed may be formed.

A plurality of the recesses may be formed, and a distance between bottoms of the adjacent recesses may be set to 110% or less of a width of the bottom.

According to the laser processing method of the present invention, the plurality of the recesses may be formed with a high density.

In addition, the present invention provides a method for producing a substrate having the recess and/or the through hole, the method including a step of forming the recess and/or the through hole on a substrate being the object to be processed by the laser processing method of the present invention.

As noted above, the laser processing method of the present invention can form a highly fine and complex pattern. Therefore, the method for producing a substrate of the present invention including the laser processing method of the present invention can produce a substrate having the highly fine and complex pattern.

In addition, the present invention provides a laser processing apparatus for forming a recess and/or a through hole on an object to be processed by using laser, the apparatus including:
a laser light source configured to oscillate the laser; and
an optical system configured to shape an irradiation shape of the laser into an irradiation shape in which an intensity of an outer portion is larger than an intensity of an inner portion in intensity distribution of the laser on a surface to be processed of the object to be processed.

By using the laser processing apparatus as above, reduction in the width of the bottom of the recess compared with the width of the opening of the recess in the initial processed surface can be inhibited even when the recess is formed with high resolution. In addition, by using the laser processing apparatus as above, reduction in the width of the opening on the lower end of the through hole compared with the width of the upper end of the through hole can be inhibited even when the through hole is formed with high resolution. Therefore, according to the laser processing apparatus of the present invention, the taper shape of the recess and/or through hole to be formed can be inhibited even when the recess and/or the through hole is formed with high resolution, and consequently the highly fine and complex pattern can be formed.

The optical system preferably includes:
a prism configured to convert laser having intensity distribution in which a laser intensity at a center is largest and a laser intensity in a base is small into laser having the irradiation shape in which the intensity of the outer portion is larger than the intensity of the inner portion in the intensity distribution of the laser; and
a shaping optical system configured to convert the irradiation shape of the laser converted by the prism into a top-hat-shaped irradiation shape.

The optical system may include, for example, the prism and the shaping optical system.

In this case, the apparatus may include a component including, for example, a roof prism or a conical prism as the prism.

For example, the prism including the roof prism or the conical prism may be used for setting the irradiation shape of the laser in which the intensity of the outer portion is larger than the intensity of the inner portion in the intensity distribution.

The laser light source preferably includes an excimer laser oscillator.

The laser light source is not particularly limited, but, for example, the excimer laser oscillator may be used. By using the excimer laser, an object to be processed composed of an organic material, such as, for example, an ABF substrate, can be efficiently processed to enable processing with high productivity. In addition, since the excimer laser has low coherence, use of the excimer laser enables extremely uniform beam formation.

The laser processing apparatus may further include:
a stage on which the object to be processed is to be mounted; and
a photomask positioned between the optical system and the stage.

The laser processing apparatus of the present invention may include the stage and the photomask as above.

In this case, the laser processing apparatus may further include a controller configured to synchronously move the object to be processed on the stage and the photomask.

The laser processing apparatus of the present invention may include such controller.

As a substrate of a first aspect, the present invention provides a substrate used for a semiconductor package substrate, wherein
the substrate includes at least two recesses on a front face of the substrate, the recesses being adjacent to each other on a cross section perpendicular to the front face,
a distance between bottoms of the recesses on the cross section is 110% or less of a width of the bottom of the recess,
a depth of the recess on the cross section is 20 µm or less, and
a ratio of the depth of the recess relative to the width of the bottom of the recess on the cross section is 1.0 or more.

In such substrate, by incorporating wiring in the recess, the highly fine and complex wiring pattern can be achieved.

The width of the bottom of the recess is preferably 70% or more of an opening width of the recess on the front face.

In such substrate, a wiring pattern with low wiring resistance can be achieved when wiring is incorporated in the recess. Since a contacting area on an interface between the wiring and the substrate can be increased, defects such as peeling of the wiring hardly occur.

The opening width of the recess on the front face is preferably 20 µm or less.

In such substrate, the more highly fine wiring pattern can be achieved.

The ratio of the depth of the recess relative to the width of the bottom of the recess on the cross section may be 1.1 or more.

Alternatively, the ratio of the depth of the recess relative to the width of the bottom of the recess may be 1.5 or more.

Alternatively, the ratio of the depth of the recess relative to the width of the bottom of the recess may be 2.4 or more.

Alternatively, the ratio of the depth of the recess relative to the width of the bottom of the recess may be 3.4 or more.

In the substrate of the first aspect, the ratio of the depth of the recess relative to the width of the bottom of the recess is 1.0 or more, and may be 1.1 or more, 1.5 or more, 2.4 or more, or 3.4 or more, for example.

For example, in the substrate, the width of the bottom of the recess may be 70% or more of the opening width of the recess, and
the ratio of the depth of the recess relative to the width of the bottom of the recess may be 2.4 or more.

In such substrate, a highly fine wiring pattern with low resistance can be more certainly achieved. Furthermore, the contacting area on the interface between the wiring and the substrate can be increased, and therefore defects such as peeling of the wiring hardly occur.

The recess may include a trench.

The plurality of the recesses may include a trench that extends in a direction parallel to the front face of the substrate, for example. Alternatively, the plurality of the recesses may be a blind hole having a circular or rectangular planar shape.

The substrate may have a back face being on an opposite side to the front face, and
the substrate may further include a through hole that goes through from the front face to the back face.

With such substrate, a package substrate further having a VIA electrode pattern can be achieved.

For example, a width of an opening on an upper end of the through hole on the front face may be 20 µm or less.

With such substrate, the highly fine and highly dense VIA electrode pattern can be achieved.

A ratio of a processing length of the through hole relative to a width of an opening on a lower end of the through hole on the back face may be 1.0 or more.

The ratio of the processing length relative to the width of the opening on the lower end of the through hole is not particularly limited, but may be 1.0 or more, for example.

A width of an opening on a lower end of the through hole on the back face is preferably 70% or more of a width of an opening on an upper end of the through hole on the front face.

With such substrate, the VIA electrode pattern with inhibited tapering from the front face to the back face can be achieved.

A ratio of a processing length of the through hole relative to a width of an opening on a lower end of the through hole on the back face is preferably 1.0 or more, and
a width of the opening on the lower end of the through hole is preferably 70% or more of a width of an opening on an upper end of the through hole on the front face.

With such substrate, the highly fine VIA electrode pattern with inhibited tapering from the front face to the back face can be achieved.

For example, a width of the bottom of the recess may be 70% or more of the opening width of the recess,
a ratio of a depth of the recess relative to a width of the bottom of the recess may be 2.4 or more,
a ratio of a processing length of the through hole relative to a width of an opening on a lower end of the through hole on the back face may be 1.0 or more, and
the width of the opening on the lower end of the through hole may be 70% or more of a width of an opening on an upper end of the through hole on the front face.

With such substrate, the highly fine wiring pattern and VIA electrode pattern with inhibited tapering from the front face to the back face can be more certainly achieved.

As a semiconductor package substrate of the first aspect, the present invention provides a semiconductor package substrate including the substrate according to the first aspect of the present invention, wherein metal wiring is embedded in the recess.

With such semiconductor package substrate, a semiconductor package having the highly fine, highly dense, and complex metal wiring pattern.

As a substrate of a second aspect, the present invention provides a substrate used for a semiconductor package substrate, including a through hole that goes through from a front face of the substrate to a back face being an opposite side to the front surface, wherein
a width of an opening on a lower end of the through hole on the back face is 70% or more of a width of an opening on an upper end of the through hole on the front face.

With such substrate of the second aspect, a semiconductor package having the VIA electrode pattern with inhibited tapering from the front face to the back face can be achieved.

The width of the opening on the upper end of the through hole on the front face is preferably 20 µm or less.

With such substrate, a semiconductor package having a highly fine, highly dense, and complex VIA electrode pattern with inhibited tapering from the front face to the back face can be achieved.

A ratio of a processing length of the through hole relative to the width of the opening on the lower end of the through hole on the back face may be 1.0 or more.

In the substrate according to the second aspect, the ratio of the processing length of the through hole relative to the width of the opening on the lower end may be set to 1.0 or more, for example.

As a semiconductor package substrate of the second aspect, the present invention provides a semiconductor package substrate including the substrate having the through hole among the substrates of the first aspect or including the substrate of the second aspect, wherein
the through hole has been subjected to a VIA processing.

The semiconductor package substrate of the second aspect can have the highly fine, highly dense, and complex VIA electrode pattern with inhibited tapering from the front face to the back face.

### ADVANTAGEOUS EFFECTS OF INVENTION

As above, the laser processing method of the present invention can inhibit the taper shape of the recess and/or through hole to be formed even when the recess and/or the through hole is formed with high resolution, and can consequently form the highly fine and complex pattern.

Furthermore, the method for producing a substrate of the present invention can produce a substrate having the highly fine and complex pattern.

The laser processing apparatus of the present invention can inhibit the taper shape of the recess and/or through hole to be formed even when the recess and/or the through hole is formed with high resolution and can provide a high-quality semiconductor package substrate having low wiring resistance, and can consequently form the highly fine and complex pattern.

The substrate of the first aspect of the present invention can achieve the highly fine, highly dense, and complex wiring pattern by incorporating wiring in the recess.

The semiconductor package substrate of the first aspect of the present invention can achieve a semiconductor package having the highly fine, highly dense, and complex metal wiring pattern.

The substrate of the second aspect of the present invention can achieve a semiconductor package having the VIA electrode pattern with inhibited tapering from the front face to the back face.

The semiconductor package substrate of the second aspect of the present invention can have the VIA electrode pattern with inhibited tapering from the front face to the back face.

### BRIEF DESCRIPTION OF DRAWINGS

FIG. 1 is a schematic view illustrating an example of a laser processing apparatus of the present invention;
FIG. 2 is a schematic view illustrating an example of laser irradiation in the laser processing method of the present invention;
FIG. 3 is a schematic view illustrating out-focus of the laser irradiation in FIG. 2;
FIG. 4 is a schematic view illustrating an example of a laser processing method of the present invention;
FIG. 5 is a schematic view illustrating another example of the laser irradiation in the laser processing method of the present invention;
FIG. 6 is a schematic sectional view illustrating an example of a recess that can be formed by the laser processing method of the present invention;
FIG. 7 is intensity distribution of an example of laser that can be used in the laser processing method of the present invention;
FIG. 8 is a schematic view illustrating an example of a conventional laser processing apparatus;
FIG. 9 is a schematic view illustrating an example of laser irradiation in a conventional laser processing method;
FIG. 10 is a schematic view illustrating out-focus of the laser irradiation in FIG. 9;
FIG. 11 is a schematic view illustrating an example of the conventional laser processing method;
FIG. 12 is a schematic view illustrating another example of the laser irradiation in the conventional laser processing method;
FIG. 13 is a schematic sectional view illustrating an example of a recess that can be formed by the conventional laser processing method;
FIG. 14 is a schematic partial sectional view illustrating an example of a substrate of a first aspect of the present invention;
FIG. 15 is a schematic partial perspective view illustrating another example of the substrate of the first aspect of the present invention;
FIG. 16 is a schematic partial sectional view illustrating another example of the substrate of the first aspect of the present invention;
FIG. 17 is a schematic partial sectional view illustrating an example of a substrate of a second aspect of the present invention;
FIG. 18 is a schematic partial sectional view illustrating an example of a semiconductor package substrate of the first aspect of the present invention;
FIG. 19 is a schematic partial sectional view illustrating an example of a semiconductor package substrate of the second aspect of the present invention;
FIG. 20 is a schematic partial sectional view illustrating another example of a semiconductor package substrate of the present invention; and
FIG. 21 is a schematic plain view of another example of the semiconductor package substrate of the present invention.

### DESCRIPTION OF EMBODIMENTS

As noted above, there has been a demand for development of: a laser processing method that can inhibit the taper shape of the recess and/or through hole to be formed even when the recess and/or the through hole is formed with high resolution, and can consequently form a highly fine and complex pattern; a method for producing a substrate that can produce a substrate having a highly fine and complex pattern; and a laser processing apparatus that can inhibit the taper shape of the recess and/or through hole to be formed even when the recess and/or the through hole is formed with high resolution, and can consequently form a highly fine and complex pattern.

The present inventors have earnestly studied the above problem, and consequently found that the taper shape of the recess and/or through hole to be formed can be inhibited even when the recess and/or the through hole is formed with high resolution, and consequently a highly fine and complex pattern can be formed by a laser processing method for forming a recess and/or a through hole on an object to be processed using laser, wherein processing is performed with an irradiation shape in which intensity distribution of the laser on a surface to be processed of the object to be processed is set such that an intensity of an outer portion is larger than an intensity of an inner portion in the intensity distribution. This finding has led to completion of the present invention.

Specifically, the present invention is a laser processing method for forming a recess and/or a through hole on an object to be processed using laser, wherein
processing is performed with an irradiation shape in which intensity distribution of the laser on a surface to be processed of the object to be processed is set such that an intensity of an outer portion is larger than an intensity of an inner portion in the intensity distribution.

In addition, the present invention is a laser processing method for forming a recess and/or a through hole on an object to be processed using laser, wherein
an optical system is used, the optical system configured to shape an irradiation shape of the laser in which an intensity of an outer portion is larger than an intensity of an inner portion in intensity distribution of the laser into a top-hat-shaped irradiation shape.

In addition, the present invention is a method for producing a substrate having the recess and/or the through hole, the method including a step of forming the recess and/or the through hole on a substrate being the object to be processed by the laser processing method of the present invention.

In addition, the present invention is a laser processing apparatus for forming a recess and/or a through hole on an object to be processed by using laser, the apparatus including:
a laser light source configured to oscillate the laser; and
an optical system configured to shape an irradiation shape of the laser into an irradiation shape in which an intensity of an outer portion is larger than an intensity of an inner portion in intensity distribution of the laser on a surface to be processed of the object to be processed.

In addition, the present invention is a substrate of a first aspect used for a semiconductor package substrate, wherein
the substrate includes at least two recesses on a front face of the substrate, the recesses being adjacent to each other on a cross section perpendicular to the front face,
a distance between bottoms of the recesses on the cross section is 110% or less of a width of the bottom of the recess,
a depth of the recess on the cross section is 20 µm or less, and
a ratio of the depth of the recess relative to the width of the bottom of the recess on the cross section is 1.0 or more.

In addition, the present invention is a semiconductor package substrate of the first aspect including the substrate of the first aspect of the present invention, wherein metal wiring is embedded in the recess.

In addition, the present invention is a substrate of a second aspect used for a semiconductor package substrate, including
a through hole that goes through from a front face of the substrate to a back face being an opposite side to the front surface, wherein
a width of an opening on a lower end of the through hole on the back face is 70% or more of a width of an opening on an upper end of the through hole on the front face.

In addition, the present invention is a semiconductor package substrate of the second aspect including the substrate having the through hole among the substrates of the first aspect or including the substrate of the second aspect, wherein
the through hole has been subjected to a VIA processing.

Hereinafter, the present invention will be described in detail, but the present invention is not limited thereto.

### Laser Processing Apparatus

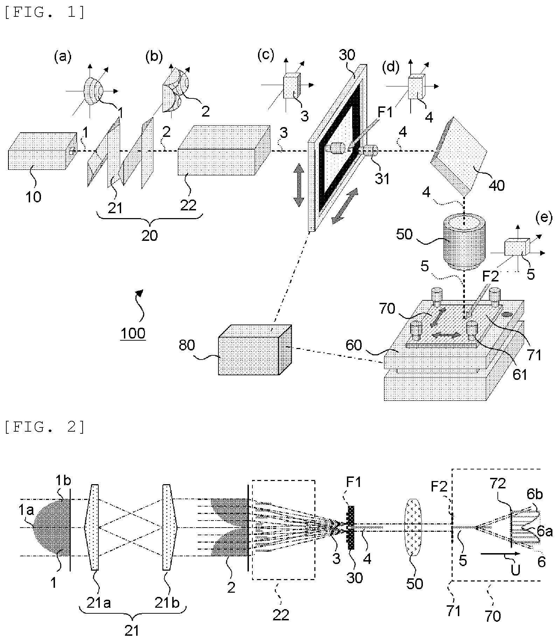

FIG. 1 is a schematic view illustrating an example of the laser processing apparatus of the present invention. A laser processing apparatus 100 illustrated in FIG. 1 is a laser processing apparatus 100 configured to form a recess and/or a through hole on an object 70 to be processed using laser. It should be noted that the laser processing apparatus 100 illustrated in FIG. 1 is an example of the laser processing apparatus of the present invention, but the laser processing apparatus of the present invention is not limited to the apparatus illustrated in FIG. 1.

The laser processing apparatus 100 illustrated in FIG. 1 has a laser light source 10 to oscillate laser 1 and an optical system 20 configured to convert intensity distribution and an irradiation shape of the laser 1 on a surface to be processed of the object 70 to be processed.

In the laser processing apparatus 100 illustrated in FIG. 1, the optical system 20 has a prism 21 and a shaping optical system 22. Although the detail will be described below, the prism 21 is a prism configured to convert laser having intensity distribution in which a laser intensity at a center is largest and a laser intensity in a base is small into laser having an irradiation shape in which an intensity of an outer portion is larger than an intensity of an inner portion in intensity distribution of the laser, and the shaping optical system 22 is a shaping optical system configured to convert the irradiation shape of the laser converted by the prism 21 into a top-hat-shaped irradiation shape. In the laser processing apparatus 100 illustrated in FIG. 1, the prism 21 includes a roof prism, but may include a conical prism.

The laser processing apparatus 100 illustrated in FIG. 1 further has a photomask 30, a reflecting mirror 40, and a reduction projection optical system 50 in this order from the optical system 20 to the object 70 to be processed in an optical path of the laser processing apparatus 100.

The laser processing apparatus 100 further includes: a stage 60 on which the object 70 to be processed is to be mounted; and a controller 80 electrically connected to the photomask 30 and the stage 60. In another aspect, the laser processing apparatus 100 further includes: a stage 60 on which the object 70 to be processed is to be mounted; and the photomask 30 provided between the optical system 20 and the stage 60.

It should be noted that the photomask 30, the reflecting mirror 40, the reduction projection optical system 50, the stage 60, and the controller 80 are optional members for the laser processing apparatus 100 of the present invention.

A light source 10 to oscillate the laser 1 is, for example, a light source (a laser oscillator) 10 to radiate (emit) the pulsed laser 1. In more detail, the laser light source 10 illustrated in FIG. 1 includes an excimer laser oscillator.

Furthermore, the laser processing apparatus 100 illustrated in FIG. 1 includes: an alignment camera 31 for a mask as an imaging means to read a feature portion of the photomask 30; and an alignment camera 61 for an object to be processed as an imaging means to read a feature portion of the object 70 to be processed. The alignment camera 31 for a mask is configured to send positional information of the feature portion of the photomask 30 to the controller 80. The alignment camera 61 for an object to be processed is configured to send positional information of the feature portion of the object 70 to be processed to the controller 80. The controller 80 is configured to adjust the relative position between the object 70 to be processed and the photomask 30 based on the above positional information. In another aspect, the controller 80 is configured to synchronously move the object 70 to be processed on the stage 60 and the photomask 30.

### Laser Processing Method

The laser processing method of the present invention may be performed by using, for example, the laser processing apparatus of the present invention, but may be performed by using an apparatus other than the laser processing apparatus of the present invention.

Hereinafter, examples of the laser processing method of the present invention that can be performed by using the laser processing apparatus 100 illustrated in FIG. 1 will be specifically described.

The laser processing method of the present invention is a laser processing method for forming a recess and/or a through hole on the object 70 to be processed using laser.

In the laser processing of the present invention, processing is performed with an irradiation shape in which intensity distribution of the laser on a surface to be processed of the object 70 to be processed is set such that an intensity of an outer portion is larger than an intensity of an inner portion in the intensity distribution. With reference to FIGS. 1 to 4, such laser processing method will be described with examples.

First, as illustrated in FIG. 1, the laser 1 having an irradiation shape illustrated in FIG. 1(a) is oscillated from the laser light source 10. The irradiation shape of the laser 1 in this example has an irradiation shape with intensity distribution in which a laser intensity of a portion on the inner side 1a is larger than a laser intensity of a portion on the outer side 1b, as illustrated in FIG. 2. In another aspect, the irradiation shape of the laser 1 has intensity distribution in which a laser intensity of a center (an inner side) 1a is largest, and a laser intensity in a base (an outer side) 1b is small.

Then, the laser 1 enters the prism 21 in the optical system 20. The prism 21 is a prism configured to convert the laser 1 into the laser 2 having an irradiation shape (FIG. 1(b)) in which the intensity of the outer portion is larger than the intensity of the inner portion in the intensity distribution of the laser 1. Illustrated in FIG. 1 is the prism 21 composed of four (two pairs of) roof prisms, as an example of the prism 21. It should be noted that in FIG. 2, only two roof prisms 21a and 21b, which are involved with the irradiation shape on a plane parallel to the paper plane, in the laser 1 are respectively illustrated.

The prism 21 is not limited to the roof prism, and a component including a conical prism may be used, for example.

It should be noted that Non Patent Document 1 discloses use of an axicon lens, which is the conical prism, but does not mention the prism configured to convert laser into the laser having the irradiation shape in which the intensity of the outer portion is larger than the intensity of the inner portion in the intensity distribution of the laser.

Then, the laser 2 that is emitted from the prism 21 and that has the irradiation shape illustrated in FIG. 1(b) and FIG. 2 enters the shaping optical system 22. As illustrated in FIG. 2, the shaping optical system 22 concentrates components of the laser 2 toward an imaging point F1, and shapes the irradiation shape of the laser 2 into a top-hat-shaped irradiation shape illustrated in FIG. 1(c) to form laser 3.

The laser 3 enters the photomask 30 at the position of the imaging point F1. The photomask 30 has a mask pattern corresponding to a pattern to be processed on the object 70 to be processed. The object 70 to be processed is scanning-irradiated with the laser through the photomask 30 to enable to form the recess and/or the through hole on the object 70 to be processed with a desired pattern.

The direction of laser 4 that is emitted from the photomask 30 and that has the irradiation shape (the top-hat shape) illustrated in FIG. 1(d) is converted by the reflecting mirror 40, and the laser 4 enters the reduction projection optical system (a projection lens) 50. An effect by using the optional reduction projection optical system 50 will be described later.

As illustrated in FIG. 2, laser 5 emitted from the reduction projection optical system 50 reaches the front face (an initial surface to be processed) 71 of the object 70 to be processed. Illustrated in FIG. 2 is an example in which an imaging point F2 of the reduction projection optical system 50 is adjusted on the front face 71 of the object 70 to be processed. However, the imaging point F2 of the reduction projection optical system 50 is not limited to the front face 71 of the object 70 to be processed.

As illustrated in FIG. 2, the irradiation shape of the laser 5 with which the front face 71 of the object 70 to be processed is irradiated is the top-hat-shape as illustrated in FIG. 1(e) and FIG. 2. Meanwhile, a surface 72 to be processed where processing further proceeds from the imaging point F2 is processed with an irradiation shape in which intensity distribution of laser 6 is set such that an intensity of an outer portion 6b is larger than an intensity of an inner portion 6a in the intensity distribution, as illustrated in FIG. 2.

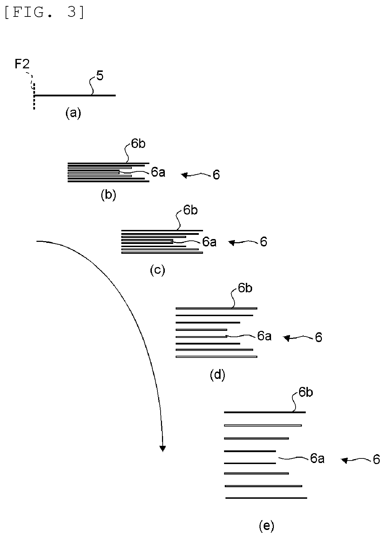

In the example illustrated in FIGS. 1 and 2, the irradiation shape of the laser 6 becomes close to the irradiation shape of the laser 2 before shaping by the shaping optical system 22 as more distanced from the imaging point F2 (under focus U), as schematically illustrated in FIGS. 3(a) to 3(e). This is the reason why the intensity of the outer portion 6b becomes larger than the intensity of the inner portion 6a in the intensity distribution of the laser 6.

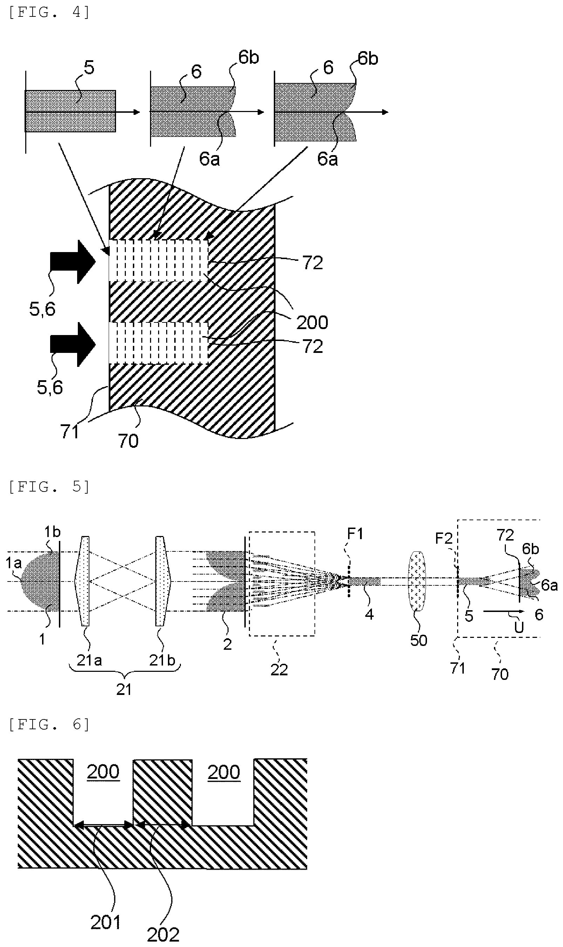

By processing the surface 72 to be processed with the irradiation shape in which intensity distribution of the laser 6 is set such that the intensity of the outer portion 6b is larger than the intensity of the inner portion 6a in the intensity distribution, by the laser processing method of the present invention, a taper shape of a recess 200 to be formed can be inhibited as schematically illustrated in FIG. 4. A through hole with inhibited tapering can be formed by continuing the processing. That is, according to the laser processing method of the present invention, deep excavation can be performed without tapering as the processing proceeds. Furthermore, according to the laser processing method of the present invention, the taper shape of the recess and/or through hole to be thus formed can be inhibited, and therefore the highly fine and complex pattern can be formed. In addition, according to the laser processing method of the present invention, the shape of the recess 200 and/or through hole to be formed can be inhibited from tapering even when the recess and/or the through hole is formed with high resolution.

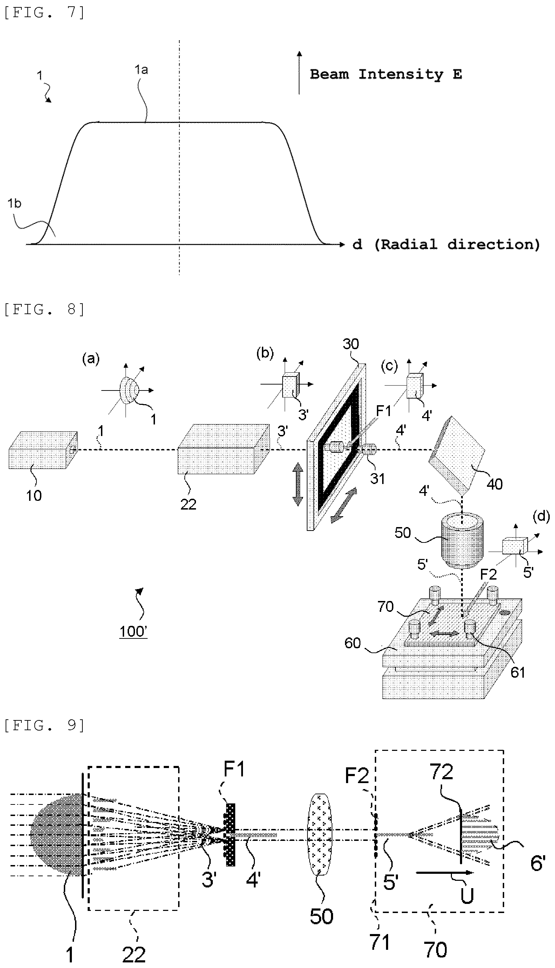

Meanwhile, as described below with reference to FIGS. 8 to 11, the shape of the recess and/or through hole to be formed cannot be inhibited from tapering if the intensity distribution of the laser on the surface to be processed of the object to be processed does not have the irradiation shape set such that the intensity of the outer portion is larger than the intensity of the inner portion in the intensity distribution.

FIG. 8 is a schematic view illustrating an example of a conventional laser processing apparatus. A laser processing apparatus 100' illustrated in FIG. 8 is the same as the laser processing apparatus 100 illustrated in FIG. 1 except that the prism 21 is not contained.

In the laser processing apparatus 100' illustrated in FIG. 8, as illustrated in FIGS. 8 and 9, laser 1 that oscillated from a laser light source 10 and that has an irradiation shape illustrated in FIG. 8(a) enters a shaping optical system 22 to become laser 3' having a top-hat-shaped irradiation shape illustrated in FIG. 8(b). The laser 3' goes through a photomask 30 positioned at an imaging point F1 of the shaping optical system 22 to become laser 4' having a top-hat-shaped irradiation shape illustrated in FIG. 8(c). The direction of the laser 4' is changed by the reflecting mirror 40, and enters a reduction projection optical system 50. Laser 5' that is emitted from the reduction projection optical system 50 and that has a top-hat-shaped irradiation shape illustrated in FIG. 8(d) reaches a front face 71 of an object 70 to be processed positioned at an imaging point F2 of the reduction projection optical system 50.

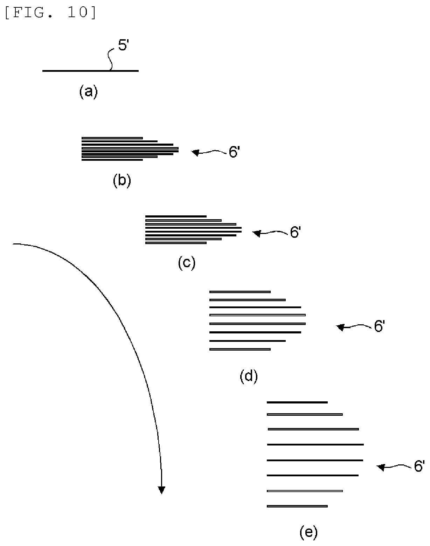

Then, as processing proceeds and a surface 72 to be processed is distanced from the front face 71 of the object 70 to be processed (under focus U), the irradiation shape of laser 6' becomes close to the irradiation shape of the laser 1 oscillated from the laser light source 10, as illustrated in FIGS. 10(a) to 10(e). Thus, in processing on the surface 72 to be processed distanced from the front face 71 of the object 70 to be processed, the intensity distribution of the laser 6' does not have the irradiation shape in which the intensity of the outer portion is larger than the intensity of the inner portion in the intensity distribution, as illustrated in FIG. 10.

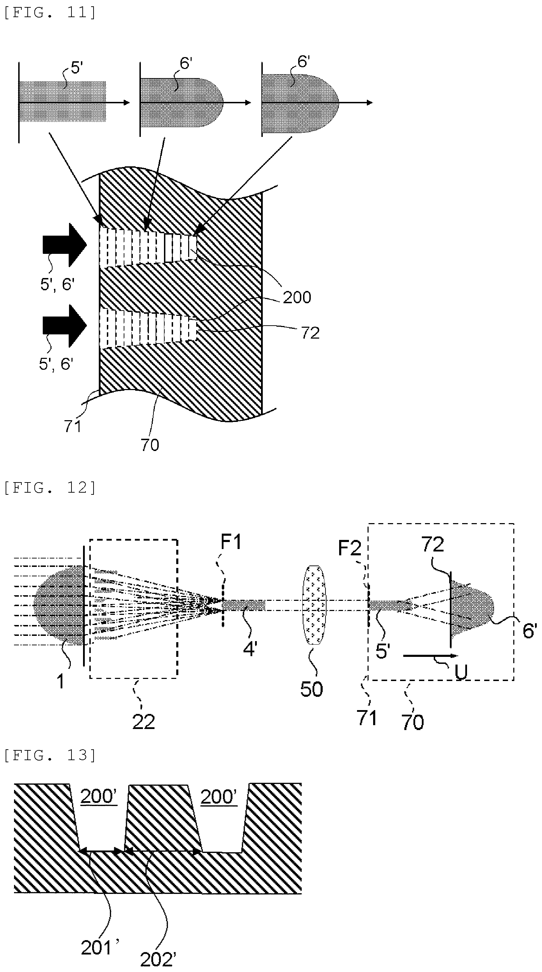

The laser processing by such method causes the taper shape of the recess and/or through hole to be formed as illustrated in FIG. 11, for example. Particularly when the recess and/or the through hole is formed with high resolution, the tapering considerably occurs to fail high-aspect processing.

In the laser processing method of the present invention, at least a part of the surface 72 to be processed of the object 70 to be processed is processed with the laser having the irradiation shape in which the intensity of the outer portion 6b is larger than the intensity of the inner portion 6a. For example, as the example illustrated in FIG. 1 and FIG. 2, the front face (the initial surface to be processed) 71 of the object 70 to be processed may be processed with the laser 5 having the top-hat-shaped irradiation shape.

In the present invention, processing can be performed while changing the shape of the intensity distribution of the laser 6 on the surface 72 to be processed of the object 70 to be processed as the processing proceeds in the depth direction of the object 70 to be processed, as illustrated in FIG. 4, for example.

In another aspect, it can also be said that the example in FIG. 4 is an example in which processing is performed while changing the shape of the intensity distribution of the laser 6 so that the intensity of the outer portion 6b is larger than the intensity of the inner portion 6a in the intensity distribution of the laser 6 as the processing proceeds in the depth direction of the object 70 to be processed.

By virtue of such processing, the shape of the recess and/or through hole to be formed can be more certainly inhibited from tapering, and consequently the highly fine and complex pattern can be more certainly formed.

Note that, in the present invention, it is only required that processing is performed with the irradiation shape in which the intensity of the outer portion 6b is larger than the intensity of the inner portion 6a in the intensity distribution of the laser 6 on at least one surface 72 to be processed of the object 70 to be processed, and the intensity distribution of the laser is not necessarily changed continuously.

In the present invention, the photomask 30 may be used in order to form the predetermined recess and/or through hole with a pattern. Also, when the photomask 30 is used, by virtue of processing with the irradiation shape in which the intensity of the outer portion 6b is larger than the intensity of the inner portion 6a in the intensity distribution of the laser 6 on the surface 72 to be processed of the object 70 to be processed, the shape of the recess and/or through hole to be formed can be inhibited from tapering, and consequently the highly fine and complex pattern can be certainly formed. Alternatively, the photomask 30 may not be used in the present invention, as illustrated in FIG. 5.

Meanwhile, even when the photomask 30 is used, the recess and/or through hole to be formed has the taper shape similarly to the example illustrated in FIG. 11 unless processing is performed with the irradiation shape in which the intensity of the outer portion 6b is larger than the intensity of the inner portion 6a in the intensity distribution. Similarly, even when the photomask 30 is not used, the recess and/or through hole to be formed has the taper shape similarly to the example illustrated in FIG. 11 unless processing is performed with the irradiation shape in which the intensity of the outer portion 6b is larger than the intensity of the inner portion 6a in the intensity distribution as illustrated in FIG. 12.

In another aspect, it can also be said that the example described with reference to FIGS. 1 to 4 is a laser processing method for forming the recess and/or the through hole on the object 70 to be processed using laser, wherein the optical system 20 is used, the optical system 20 is configured to convert the laser 1 into the laser 2 having the irradiation shape in which the intensity of the outer portion is larger than the intensity of the inner portion in the intensity distribution, and configured to further shape the laser 3 having the top-hat-shaped irradiation shape.

By processing the object 70 to be processed with laser using such optical system 20, it is possible to perform processing with the irradiation shape of the laser 6 in which the intensity of the outer portion 6b is larger than the intensity of the inner portion 6a in at least a part distanced from the front face in the object 70 to be processed. Furthermore, according to such laser processing method, reduction in the width of the bottom of the recess compared with the width of the opening of the recess in the initial processed front face 71 can be inhibited even when the recess is formed with high resolution. In addition, according to such laser processing method, reduction in the width of the opening on the lower end of the through hole compared with the width of the upper end of the through hole can be inhibited even when the through hole is formed with high resolution. That is, according to the laser processing method of the present invention expressed by this aspect, the shape of the recess and/or through hole to be formed can be inhibited from tapering even when the recess and/or the through hole is formed with high resolution, and consequently the highly fine and complex pattern can be formed.

The object 70 to be processed being the object of the laser processing in the present invention is not particularly limited, but a semiconductor package substrate may be the object 70 to be processed, for example.

Processing the semiconductor package substrate includes a processing pattern in which the through hole and the recess, for example, VIA processing and groove processing are mixed. In this case, the processing can be performed in the single step by the method of the present invention without separating steps for the VIA processing and the groove processing from each other. Furthermore, the semiconductor package substrate has had higher density, and in a laser drilling method, conventionally performed in the VIA processing, the processing time increases due to an increased number of processing holes involved with the higher density. In contrast, in the present method, there is not increase the processing time due to the increased number of processing holes and the finer pattern.

According to the present invention, the object 70 to be processed may be subjected to ablation processing, for example. With the ablation processing, the laser may be freely set within a range that the energy of the laser 5 and 6 is absorbed by the object 70 to be processed in wavelengths and energy densities that enable the ablation processing.

As described above, according to the present invention, the highly fine pattern of the recess and/or the through hole can be formed. Specifically, according to the present invention, the recess and/or the through hole having a width of 20 µm or less with inhibited tapering, for example, can be formed. In contrast, it is difficult to form the recess and/or the through hole having a width of 20 µm or less with inhibited tapering by the laser processing apparatus 100' of the conventional example in FIGS. 8 to 12.

Furthermore, the recess and/or the through hole that can be formed by the present invention can have a depth of 20 µm or less, for example. It should be noted that by setting the processing depth to be smaller than a thickness of the object 70 to be processed, the recess can be formed. Alternatively, by setting the processing depth to be equal to the thickness of the object 70 to be processed, the through hole can be formed.

As another aspect, according to the present invention, a pattern of the recess and/or the through hole with a high aspect ratio can be formed. According to the present invention, the recess in which a ratio of a height of a processed portion relative to a width of a bottom of the recess is **1.0** or more, for example, can be formed. According to the present invention, the recess in which a ratio of a height of a processed portion relative to a width of an opening on a lower end of the through hole is **1.0** or more, for example, can be formed. In contrast, it is difficult for the laser processing apparatus 100' of the conventional example in FIGS. 8 to 12 to form the recess and/or the through hole having an aspect ratio of 1.0 or more while inhibiting tapering.

In still another aspect, according to the present invention, for example, the recess in which a width of a bottom of the recess is 70% or more of an opening width of the recess on an initial processed surface of the object to be processed can be formed, and/or the through hole in which a width of an opening on a lower end of the through hole is 70% or more of a width of an opening on an upper end of the through hole on the initial processed surface of the object to be processed can be formed.

Further, since the recess can be formed while inhibiting tapering in the present invention, a plurality of the recesses 200 may be formed, and a distance 202 between bottoms of the adjacent recesses 200 may be set to 110% or less of a width 201 of the bottom, as illustrated in FIG. 6. Therefore, in the present invention, the plurality of the recesses 200 can be formed with a high density.

Meanwhile, when a plurality of recesses 200' are formed by the conventional laser processing method as in FIG. 13, for example, each of the recesses 200' is formed with tapering. Thus, a distance 202' between bottoms of the adjacent recesses 200' exceeds 110% of a width 201' of the bottom, and consequently fails to form the plurality of the recesses 200' with a high density.

Hereinafter, optional matters of the laser processing method and the laser processing apparatus of the present invention will be described, but the present invention is not limited to the specific examples described above and modified examples described below.

### <Laser and Laser Light Source>

The laser 1 is not particularly limited, but excimer laser may be used, for example. Use of the excimer laser can efficiently process the object to be processed composed of an organic material, such as, for example, an ABF substrate, to enable processing with high productivity. In addition, since the excimer laser has low coherence, use of the excimer laser can achieve extremely uniform beam formation.

In addition, use of the excimer laser can accurately adjust the processing depth and width of the recess and/or the through hole compared with solid laser. Specifically, the excimer laser is useful for forming a recess such as a blind hole and a trench. Therefore, by virtue of use of the excimer laser, complex protrusions-and-recesses forming process such as a circuit substrate can be accurately performed.

It should be noted that the irradiation shape of the laser 1 oscillated by the laser light source 1 is not limited to the shapes illustrated in FIGS. 1, 2, and 5. For example, the irradiation shape may have intensity distribution in which a laser intensity of a center (an inner side) 1a is largest and a laser intensity of a base (an outer side) 1b is small, as the irradiation shape illustrated in FIG. 7.

### <Scanning Irradiation>

In the present invention, processing may be performed while relatively scanning the laser 5 and 6 relative to the front face 71 to be processed. That is, the laser processing of the present invention may be scanning processing.

By performing the scanning processing, accurate laser processing can be performed also on the object 70 to be processed having a large area.

By performing the scanning processing, increase in the processing time can be prevented even when a number of the recesses and/or through holes to be processed increases.

The scanning processing can be performed by synchronously moving the object 70 to be processed on the stage 60 and the photomask 30, for example.

Thus, the laser processing can be performed without moving the laser 1 to 6 itself.

Also, in this aspect, the processed region is not limited to the area of the lens, and thus, a larger area (field angle) than the area of the lens can be processed.

Furthermore, in this aspect, the size of the reduction projection optical system 50 required for the irradiation can be reduced, and accuracy of the laser irradiation position and temperature controllability become better. Further, since the size of the reduction projection optical system 50 described below can be reduced, image strain due to the irradiation is reduced.

In the laser processing apparatus 100 illustrated in FIG. 1, the object 70 to be processed on the stage 60 and the photomask 30 can be synchronously moved by using the controller 80.

In more detail, the controller 80 is configured to adjust the relative position between the object 70 to be processed and the photomask 30 based on positional information of a feature portion of the photomask 30 obtained by an alignment camera 31 for a mask and positional information of a feature portion of the object 70 to be processed obtained by an alignment camera 61 for an object to be processed.

### <Reduction Projection Optical System>

The laser processing apparatus 100 illustrated in FIG. 1 has the reduction projection optical system 50 to enable to enlarge the mask pattern formed on the photomask 30 compared with the processing pattern that is to be actually formed on the object to be processed.

By virtue of the enlargement of the mask pattern formed on the photomask 30 compared with the actual processing pattern, the energy of the laser 3 that reaches the photomask 30 can be reduced compared with the actual processing energy. When the reduction ratio of the reduction projection optical system 50 is N, the energy of the laser that reaches the mask surface relative to the processing energy on the surface of the object 70 to be processed is 1/(N²). This can inhibit thermal drift due to the energy of the laser 3, and consequently thermal expansion of the photomask 30 can be inhibited, and accurate processing can be performed even after processing operation for a long time.

Further, deterioration of the optical members (for example, the optical system 20 and the photomask 30) due to heat of the laser can also be inhibited, and thus, lifetimes of the optical members can be lengthened.

The reduction projection optical system 50 may have one pair of reduction projection lens. When the reduction projection optical system 50 is an infinite-distance optical system, magnification with the reduction projection optical system 50 can be adjusted by, for example, a ratio between focal distances of the reduction projection lens and by a distance between the reduction projection lens.

NA of the reduction projection lens is preferably selected according to an energy density required for processing the object 70 to be processed and processing resolution. The NA of the reduction projection lens is preferably 0.12 or more. The present invention can inhibit the taper shape of the recess and/or through hole to be formed even with the laser processing with high NA for formation with high resolution.

The laser processing apparatus 100 of the present invention preferably further includes a temperature-adjusting means for adjusting a temperature of the reduction projection optical system 50.

By including the temperature-adjusting means, the thermal effect due to the laser energy on the reduction projection optical system 50 can be further inhibited. In the reduction projection optical system 50, the laser 4 passed through the photomask 30 is projected with a reduced size of 1/N. Thus, the energy of the laser that goes through the lens portion on a tip facing the object becomes N² times relative to the energy of the laser on the photomask 30, and a thermal effect tends to appear in this portion. Therefore, by imparting the temperature-adjusting function to the reduction projection optical system 50 in order to inhibit this thermal energy, thermal drift due to the laser energy can be inhibited and accurate processing can be performed even after processing operation for a long time.

Furthermore, in the laser processing method and the laser processing apparatus 100 of the present invention, a reduction projection lens having extremely small diameter can be used. The temperature-adjusting means for the reduction projection lens cannot directly impart the temperature-adjusting means to the lens itself but cools a jacket portion holding the lens. Therefore, when the lens diameter increases, the temperature in the peripheral portion of the lens can be managed but the temperature-adjusting effect is hardly provided near the important center portion, which causes difficulty in heat management. Therefore, even slight energy absorption inside the lends due to the laser irradiation for a long time easily causes strain due to the heat. In the laser processing apparatus 100 including the temperature-adjusting function for the reduction projection optical system 50, the lens diameter can be reduced, and consequently such defects can be inhibited.

Further, failure due to the laser irradiation to the reduction projection optical system 50 can be inhibited to lengthen the lifetime.

### Method for Producing Substrate

The method for producing a substrate of the present invention is a method for producing a substrate having the recess and/or the through hole, the method including a step of forming the recess and/or the through hole on a substrate being the object to be processed by the laser processing method of the present invention.

As described above, the laser processing method of the present invention can form the highly fine and complex pattern. Therefore, according to the method for producing the substrate of the present invention including the laser processing method of the present invention, a substrate having the highly fine and complex pattern can be produced.

### Substrate

The substrate of the present invention is a substrate used for a semiconductor package substrate. The substrate of the present invention is roughly classified into two aspects of: a substrate of a first aspect having at least two recesses; and a substrate of a second aspect having a through hole. A substrate having at least two recesses and a through hole can be encompassed in both the first aspect and the second aspect.

Hereinafter, each example of the substrate of the first aspect and the substrate of the second aspect will be described in more detail with reference to the drawings.

### <First Aspect>

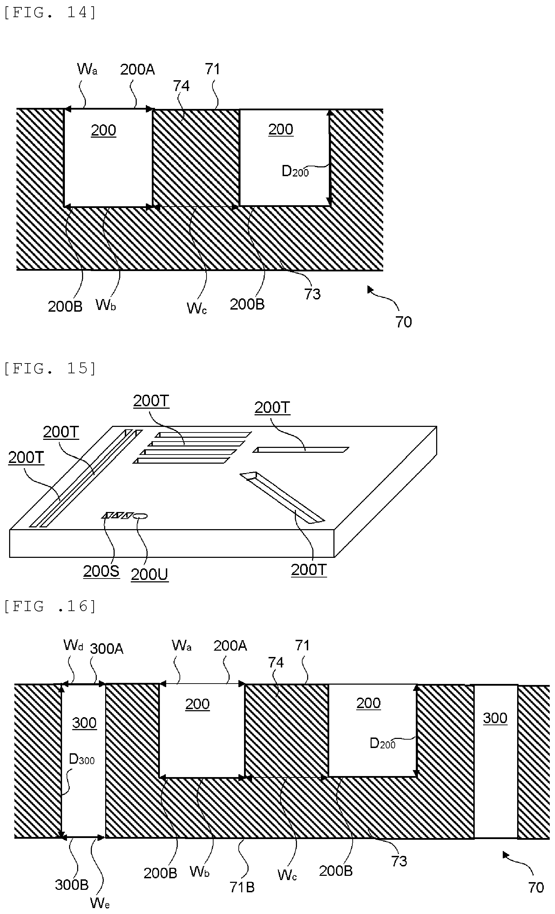

FIG. 14 is a schematic partial sectional view of an example of the substrate of the first aspect of the present invention. A substrate 70 illustrated in FIG. 14 is a substrate used for a semiconductor package substrate.

The substrate 70 has at least two recesses 200 on its front face 71, and the recesses 200 are adjacent on a cross section 73 perpendicular to the front face 71. Each of the recesses 200 has an opening 200A on the front face 71 of the substrate 70 and a bottom 200B. The substrate 70 has a protrusion 74 between the recesses 200 adjacent to each other. The at least two recesses 200 may have shapes same as each other or may have shapes different from each other. That is, an opening width Wₐ being a width of the opening 200A and a width W_{b} of the bottom 200B of the recesses 200 may be equal to each other or all of them may be different. Also, a processing depth D₂₀₀ of the recess 200 (for example, a depth of the recess 200 in a thickness direction of the substrate 70) may be different in each recess 200, or there may be the equal processing depth D₂₀₀.

A distance W_{c} between the bottoms 200B of the recesses 200 on the cross section 73 of the substrate 70 is 110% or less, preferably 100% or more and 110% or less, and more preferably 100% or more and 105% or less of the width W_{b} of the bottom 200B of the recess 200. The width W_{b} of the bottom 200B of the recess 200 herein is an average of the widths W_{b} of the bottoms 200B of the recesses 200 adjacent to each other. Also, the distance W_{c} between the bottoms 200B of the recesses 200 is the shortest distance between the bottoms 200B of the recesses 200. It should be noted that the substrate 70 of the first aspect of the present invention is only required to have the at least two recesses 200 in which the distance W_{c} between the bottoms 200B of the recesses 200 is 110% or less of the width W_{b} of the bottom 200B of the recess 200, and may have a recess not satisfying such relationship.

Furthermore, in the substrate 70, the depth D₂₀₀ of the recess 200 on the cross section 73 is 20 µm or less. Also, in the substrate 70, a ratio (D₂₀₀/W_{b}) of the depth D₂₀₀ of the recess 200 relative to the width W_{b} of the bottom 200B of the recess 200 on the cross section 73 is 1.0 or more.

In such substrate 70, the distance W_{c} between the bottoms 200B of the recesses 200 is 110% or less of the width W_{b} of the bottom 200B of the recess 200, and the depth D₂₀₀ of the recess 200 is 20 µm or less. Since the ratio (D₂₀₀/W_{b}) of the depth D₂₀₀ of the recess 200 relative to the width W_{b} of the bottom 200B of the recess 200 satisfies to be 1.0 or more, the width W_{b} can be significantly small. Therefore, such substrate 70 can have the highly fine recess pattern. Furthermore, by incorporating wiring, for example, metal wiring, in the such recesses 200 of the substrate 70, a highly fine and complex wiring pattern can be achieved.

The substrate of the first aspect as above can be produced by the laser processing method of the present invention or the method for producing a substrate of the present invention that have been described above, for example. The substrate of the first aspect as above can be produced by using the laser processing apparatus of the present invention described above, for example.

Therefore, for example, the width W_{b} of the bottom 200B of the recess 200 may be set to 70% or more, preferably 80% or more, and more preferably 90% or more of the opening width Wa of the recess 200 on the front face 71.

In such substrate 70, the recess 200 does not have a taper shape but a shape close to a cylindrical shape. Thus, when wiring is incorporated in this recess 200, this wiring can exhibit low resistance. Therefore, the substrate 70 of such aspect can achieve the wiring pattern having low wiring resistance. In addition, since a contacting area on an interface between the wiring and the substrate can be increased, defects such as peeling of the wiring hardly occur.

The width W_{b} of the bottom 200B of the recess 200 is ideally equal to (100% of) the opening width Wₐ.

For example, the opening width Wₐ of the recess 200 on the front face 71 is preferably 20 µm or less.

Such substrate 70 can achieve the more highly fine wiring pattern. The lower limit is not particularly limited, but the opening width Wₐ of the recess 200 on the front face 71 may be 1 µm or more and 20 µm or less, for example.

In the substrate 70 of the first aspect, the ratio D₂₀₀/W_{b} is only required to be 1.0 or more, and may be 1.1 or more, 1.5 or more, 2.4 or more, or 3.4 or more, for example. An upper limit of the ratio D₂₀₀/W_{b} is not particularly limited, but the ratio D₂₀₀/W_{b} may be 10.0 or less, for example.

The opening width Wₐ of the recess 200 on the front face 71 may be 20 µm or less.

With such substrate, the more highly fine wiring pattern can be achieved. A lower limit of the opening width Wₐ is not particularly limited, but may be 1 µm or more, for example.

For example, the substrate 70 of the first aspect may be a substrate in which the width W_{b} of the bottom 200B of the recess 200 is 70% or more of the opening width Wₐ of the recess 200 and in which the ratio of the depth D₂₀₀ of the recess 200 relative to the width W_{b} of the bottom 200B of the recess 200 is 2.4 or more.

With such substrate 70, the highly fine and complex wiring pattern with low resistance can be more certainly achieved.

The recess 200 may include a trench 200T as illustrated in a perspective view of FIG. 15, for example. The trench 200T extends in a direction parallel to the front face 71 of the substrate 70. A plurality of the trenches 200T may have extending directions different from each other, as illustrated as an example in FIG. 15.

The recess 200 is not limited to the trench 200T. For example, the recess 200 may include a blind hole 200S having a rectangular surface shape or a blind hole 200U having a circular surface shape as the example illustrated in FIG. 15. A recess 200 having another surface shape may be included.

When the recess 200 having the ratio D₂₀₀/W_{b} of 1.0 or more is the trench 200T, the width W_{b} and the opening width Wₐ are defined as a width of the trench 200T in a direction perpendicular to the extending direction of the trench. When the recess 200 having the ratio D₂₀₀/W_{b} of 1.0 or more is the blind hole 200S having a rectangular surface shape, the smallest width in the surface shape is defined as the width W_{b} and the opening width Wₐ. When a plurality of the recesses 200 having the ratio D₂₀₀/W_{b} of 1.0 or more are the blind holes 200U having a circular surface shape, the diameter of the circle is defined as the width W_{b} and the opening width Wₐ. When the surface shape is an ellipse, its minor diameter is defined as the width W_{b} and the opening width Wₐ.

It should be noted that, as described above, the substrate 70 of the first aspect of the present invention is only required to have the at least two recesses 200 having the ratio D₂₀₀/W_{b} of 1.0 or more, and not all the recesses necessarily satisfy the ratio D₂₀₀/W_{b} of 1.0 or more.

The processing depth D₂₀₀ of the recess 200 on the cross section 73 (for example, the depth of the recess 200 in the thickness direction of the substrate 70) may be different in each recess 200, or there may be the same processing depth D₂₀₀. The processing depth D₂₀₀ of the recess 200 may be 5 µm or more and 20 µm or less, for example.

In a modified example, the substrate 70 of the first aspect may have a back face 71B being on an opposite side to the front face 71 of the substrate 70, and may further have a through hole 300 that goes through from the front face 71 to the back face 71B, as illustrated in FIG. 16.

With such substrate 70, the package substrate further having a VIA electrode pattern can be achieved.

For example, a width W_{d} of an opening 300A on an upper end of the through hole 300 on the front face 71 is preferably 20 µm or less.

With such substrate 70, the highly fine and highly dense VIA electrode pattern can be achieved.

A lower limit of the width W_{d} of the opening 300A on the upper end is not particularly limited, but the width W_{d} may be 1 µm or more, for example.

A ratio of a processing length D₃₀₀ of the through hole 300 relative to a width Wₑ of an opening 300B on a lower end of the through hole 300 on the back face 71B may be 1.0 or more.

An upper limit of the ratio of the processing length D₃₀₀ relative to the width Wₑ of the opening 300B on the lower end of the through hole 300 is not particularly limited, and the ratio may be 1.0 or more and 10.0 or less, for example.

The substrate 70 having such through hole 300 can be also formed by, for example, the laser processing method of the present invention or the method for producing a substrate of the present invention that have been described above. Also, the substrate 70 can be produced by using the laser processing apparatus of the present invention described above, for example.

Therefore, the width Wₑ of the opening 300B on the lower end of the through hole 300 on the back face 71B may be 70% or more of the width W_{d} of the opening 300A on the upper end of the through hole 300 on the front face 71, and the substrate preferably has such through hole 300. The substrate 70 as above having the through hole 300 and the at least two recesses 200, described above, is the substrate of the first aspect and is the substrate of the second aspect.

In such substrate 70, the through hole 300 does not have a taper shape but a shape close to a cylindrical shape. Thus, when this through hole 300 is subjected to VIA processing, the VIA electrode thus formed can exhibit low resistance. In addition, since a contacting area on an interface between the wiring and the substrate can be increased, defects such as peeling of the wiring hardly occur. Therefore, the substrate 70 of such modified example can achieve the highly fine and complex VIA electrode pattern with low resistance.

The width Wₑ of the opening 300B on the lower end of the through hole 300 is ideally equal to (100% of) the width W_{d} of the opening 300A on the upper end. The width Wₑ of the opening 300B on the lower end of the through hole 300 may be 70% or more, preferably 80% or more, and further preferably 90% or more of the width W_{d} of the opening 300A on the upper end.

For example, in the substrate 70 of the first aspect, the ratio of the processing length D₃₀₀ of the through hole 300 relative to the width Wₑ of the opening 300B on the lower end of the through hole 300 may be 1.0 or more on the back face 71B, and the width Wₑ of the opening 300B on the lower end of the through hole 300 may be 70% or more of the width W_{d} of the opening 300A on the upper end of the through hole 300 on the front face 71. Such aspect is preferable.

With such substrate 70, the highly fine VIA electrode pattern with inhibited tapering from the front face to the back face can be certainly achieved. In addition, since a contacting area on an interface between the wiring and the substrate can be increased, defects such as peeling of the wiring hardly occur.

For example, the substrate 70 of the first aspect may be a substrate in which the width W_{b} of the bottom 200B of the recess 200 is 70% or more of the opening width Wₐ of the recess 200, in which the ratio of the depth D₂₀₀ of the recess 200 relative to the width W_{b} of the bottom 200B of the recess 200 is 2.4 or more, in which the ratio of the processing length D₃₀₀ of the through hole 300 relative to the width Wₑ of the opening 300B on the lower end of the through hole 300 is 1.0 or more on the back face 71B, and in which the width Wₑ of the opening 300B on the lower end of the through hole 300 is 70% or more of the width W_{d} of the opening 300A on the upper end of the through hole 300 on the front face 71.

With such substrate 70, the highly fine VIA electrode pattern with inhibited tapering from the front face to the back face can be more certainly achieved. In addition, since a contacting area on an interface between the wiring and the substrate can be increased, defects such as peeling of the wiring hardly occur.

The planar shape of the through hole 300 is not particularly limited. When the through hole 300 has a rectangular surface shape, the smallest width in the surface shape is defined as the width W_{d} and the width Wₑ. When the through hole 300 has a circular surface shape, the diameter of the circle is defined as the width W_{d} and the width Wₑ. When the surface shape is an ellipse, its minor diameter is defined as the width W_{d} and the width Wₑ.

### <Second Aspect>

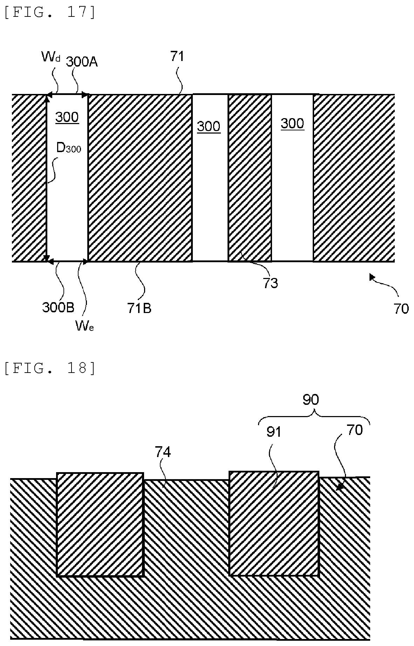

FIG. 17 is a schematic partial sectional view of an example of the substrate of the second aspect of the present invention. A substrate 70 illustrated in FIG. 17 is a substrate used for a semiconductor package substrate.

The substrate 70 has a through hole 300 that goes through from a front face 71 to a back face 71B being an opposite side to the front surface 71, and a width Wₑ of an opening 300B on a lower end of the through hole 300 on the back face 71B is 70% or more of a width W_{d} of an opening 300A on an upper end of the through hole 300 on the front face 71.

In the substrate 70 as above, the through hole 300 does not have a taper shape but a shape close to a cylindrical shape. Thus, when this through hole 300 is subjected to VIA processing, the VIA electrode thus formed can exhibit low resistance. Therefore, the substrate 70 of such aspect can achieve the VIA electrode pattern with low resistance.

Since the through hole 300 does not have the taper shape, the width W_{d} of the opening 300A on an upper end of the through hole 300 is unnecessarily enlarged in order to keep the size of the width Wₑ of the opening 300B on a lower end of the through hole 300. Thus, the substrate 70 of this aspect can also achieve the highly fine and complex VIA pattern.

The width Wₑ of the opening 300B on the lower end of the through hole 300 is ideally equal to (100% of) the width W_{d} of the opening 300A on the upper end. The width Wₑ of the opening 300B on the lower end of the through hole 300 may be 70% or more, preferably 80% or more, and further preferably 90% or more of the width W_{d} of the opening 300A on the upper end.

The number of the through hole 300 may be one, or may be plural. When the plurality of the through holes 300 are contained, the widths W_{d} and the widths Wₑ of the plurality of the through holes 300 may be equal to each other or may be different from each other.

The planar shape of the through hole 300 is not particularly limited. When the through hole 300 has a rectangular surface shape, the smallest width in the surface shape is defined as the width W_{d} and the width Wₑ. When the through hole 300 has a circular surface shape, the diameter of the circle is defined as the width W_{d} and the width Wₑ. When the surface shape is an ellipse, its minor diameter is defined as the width W_{d} and the width Wₑ.

Such substrate 70 can be formed by, for example, the laser processing method of the present invention or the method for producing a substrate of the present invention that have been described above. The substrate 70 can be produced by using the laser processing apparatus of the present invention described above, for example.

The width W_{d} of the opening 300A on the upper end of the through hole 300 on the front face 71 is preferably 20 µm or less.

With such substrate 70,the semiconductor package having the more highly fine VIA electrode pattern can be achieved.

The lower limit of the width W_{d} of the opening 300A on the upper end is not particularly limited, and may be 1 µm or more, for example.

A ratio of the processing depth D₃₀₀ of the through hole 300 relative to the width Wₑ of the opening 300B on the lower end of the through hole 300 on the back face 71B may be 1.0 or more, for example. The ratio of the processing depth D₃₀₀ relative to the width Wₑ of the opening 300B on the lower end of the through hole 300 is not particularly limited, but may be 1.0 or more and 10.0 or less, for example.

The substrate 70 of the second aspect may further have a recess that does not go through from the front face 71 to the back face 71B. For example, similarly to the case illustrated in FIG. 16, the substrate 70 may have at least two recesses 200, and may be a substrate 70 in which the depth D₂₀₀ of the recess 200 on the cross section 73 is 20 µm or less, and the ratio (D₂₀₀/W_{b}) of the depth D₂₀₀ of the recess 200 relative to the width W_{b} of the bottom 200B of the recess 200 on the cross section 73 is 1.0 or more. It can also be said that such substrate 70 is the substrate of the first aspect.

It should be noted that, as described above, the substrate of the present invention can be formed by, for example, the laser processing method of the present invention or the method for producing a substrate of the present invention, but may be produced by another method. The substrate of the present invention can be produced by using, for example, the laser processing apparatus of the present invention, but may be produced by using another apparatus.

### Semiconductor Package Substrate

The semiconductor package substrate of the present invention is a substrate used for a semiconductor package. The semiconductor package plays roles of, for example, protecting a semiconductor device from external environment and providing an external-connection wiring terminal in mounting this device on a printed wiring board, etc. That is, the semiconductor package substrate is the substrate used for the semiconductor package, and may be those mounting the semiconductor device, or may be those not mounting the semiconductor device. The substrate may have or may not have a member for protecting the semiconductor device. Hereinafter, the substrate not having a semiconductor device and the member for protecting the semiconductor device will be described as an example with reference to the drawings.

FIG. 18 shows a schematic partial sectional view of an example of a semiconductor package substrate of the first aspect of the present invention.

A semiconductor package substrate 90 illustrated in FIG. 18 includes the substrate 70 of an example of the first aspect of the present invention, which has been described with reference to FIG. 14.

Also, in the semiconductor package substrate 90 illustrated in FIG. 18, metal wiring 91 is embedded in each of the recesses 200 illustrated in FIG. 14. In another aspect, the semiconductor package substrate 90 may have the metal wiring 91 sandwiched by protrusions 74 of the substrate 70.

By virtue of the presence of the recess 200 of the substrate 70, the highly fine and complex wiring pattern can be achieved, as described above. Therefore, with such semiconductor package substrate 90 the semiconductor package having the highly fine and complex pattern of the metal wiring 91 can be achieved. In addition, since a contacting area on an interface between the wiring and the substrate can be increased, defects such as peeling of the wiring hardly occur.

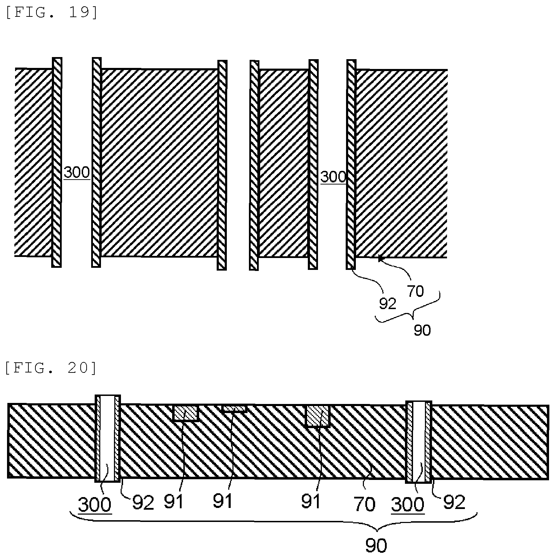

FIG. 19 shows a schematic partial sectional view of an example of a semiconductor package substrate of the second aspect of the present invention.

A semiconductor package substrate 90 illustrated in FIG. 19 has the substrate 70 of an example of the second aspect of the present invention illustrated in FIG. 17.

In the semiconductor package substrate 90 illustrated in FIG. 19, the through hole 300 has been subjected to VIA processing. In more detail, a VIA electrode 92 is formed on a face defining the through hole 300 in the substrate 70.

The substrate 70 of the second aspect can achieve the highly fine VIA electrode pattern with inhibited tapering from the front face to the back face for the aforementioned reason. Therefore, the semiconductor package substrate 90 of the second aspect can have the highly fine VIA electrode pattern with inhibited tapering from the front face to the back face.

It should be noted that the VIA electrode 92 in FIG. 19 has a hollow portion (the through hole 300), but the VIA electrode 92 may not have the hollow portion.

The semiconductor package substrate 90 of the second aspect may further have embedded metal wiring 91 as illustrated in FIG. 20, for example. This metal wiring 91 is embedded in each of the recesses 200, described in the substrate of the first aspect. Therefore, it can also be said that the semiconductor package substrate 90 of the example illustrated in FIG. 20 is an example of the semiconductor package substrate of the first aspect.

Note that the size of the metal wiring 91 may be different from each other as illustrated in FIG. 20, or there may be the equal size.

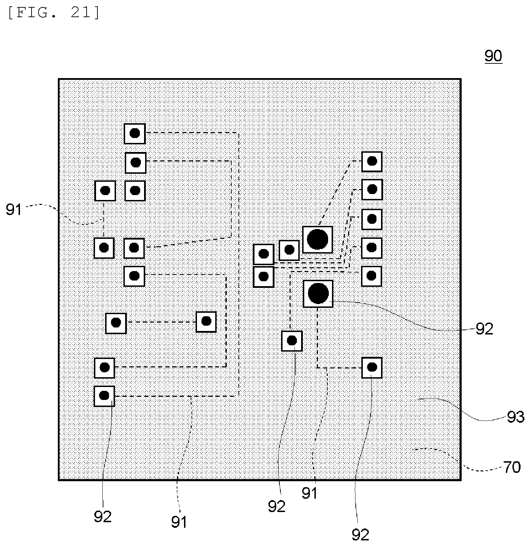

The semiconductor package substrate 90 of the present invention may further have, for example, a surface insulative film 93 as an example illustrated in FIG. 21 as a plain view. As shown with a broken line, the surface insulative film 93 can cover the metal wiring 91. Meanwhile, a part of the VIA electrode 92 may be exposed, as illustrated in FIG. 21.

According to the present invention, a plurality of the complex metal wiring 91 can be formed as the highly fine and complex pattern between the VIA electrodes 92, as illustrated in FIG. 21, for example.

It should be noted that the substrate being the processing target of the present invention may be or may not be provided with a circuit such as metal wiring or a resist.

Furthermore, each of the substrate being the processing target by the laser processing method of the present invention, the substrate of the present invention, and the semiconductor package substrate of the present invention may have a rectangular planar shape, or may have another shape such as a circular, ellipse, or polygonal planer shape, for example.

The present description includes the following embodiments:
[1] A laser processing method for forming a recess and/or a through hole on an object to be processed using laser, wherein processing is performed with an irradiation shape in which intensity distribution of the laser on a surface to be processed of the object to be processed is set such that an intensity of an outer portion is larger than an intensity of an inner portion in the intensity distribution.
[2] The laser processing method according to [1], wherein processing is performed while changing the shape of the intensity distribution of the laser on the surface to be processed of the object to be processed as the processing proceeds in a depth direction of the object to be processed.
[3] The laser processing method according to [2], wherein processing is performed while changing the shape of the intensity distribution of the laser so that the intensity of the outer portion is larger than the intensity of the inner portion in the intensity distribution of the laser as the processing proceeds in the depth direction of the object to be processed.
[4] The laser processing method according to [3], wherein processing is performed while changing the shape of the intensity distribution of the laser so that the intensity of the outer portion is larger than the intensity of the inner portion in the intensity distribution of the laser as the processing proceeds in the depth direction of the object to be processed by passing laser having intensity distribution in which a laser intensity at a center is largest and a laser intensity in a base is small through a prism.
[5] The laser processing method according to [4], wherein a component comprising a roof prism or a conical prism is used as the prism.
[6] A laser processing method for forming a recess and/or a through hole on an object to be processed using laser, wherein an optical system is used, the optical system is configured to shape an irradiation shape of the laser in which an intensity of an outer portion is larger than an intensity of an inner portion in intensity distribution of the laser into a top-hat-shaped irradiation shape.
[7] The laser processing method according to [6], wherein an initial surface to be processed of the object to be processed is processed with laser having the top-hat-shaped irradiation shape, and at least a part of the object to be processed except for the initial surface to be processed is processed with laser having the irradiation shape in which the intensity of the outer portion is larger than the intensity of the inner portion.
[8] The laser processing method according to any one of [1] to [7], wherein a substrate for a semiconductor package is processed as the object to be processed to form a recess and/or a through hole on the substrate for a semiconductor package.
[9] The laser processing method according to any one of [1] to [7], wherein the laser is oscillated by using an excimer laser oscillator.
[10] The laser processing method according to any one of [1] to [9], wherein the object to be processed is irradiated with the laser through a photomask.
[11] The laser processing method according to any one of [1] to [10], wherein processing is performed while relatively scanning the laser relative to the surface to be processed.
[12] The laser processing method according to any one of [1] to [11], wherein ablation processing is performed.
[13] The laser processing method according to any one of [1] to [12], wherein the recess and/or the through hole having a width of 20 µm or less is formed.
[14] The laser processing method according to any one of [1] to [13], wherein the recess and/or the through hole having a depth of 20 µm or less is formed.
[15] The laser processing method according to any one of [1] to [14], wherein, as the recess and/or the through hole, a recess and/or a through hole in which a ratio of a height of processed portion relative to a width of a bottom of the recess or to a width of an opening on a lower end of the through hole is **1.0** or more is formed.
[16] The laser processing method according to any one of [1] to [15], wherein the recess is formed in which a width of a bottom of the recess is 70% or more of an opening width of the recess on an initial processed surface of the object to be processed, and/or the through hole is formed in which a width of an opening on a lower end of the through hole is 70% or more of a width of an opening on an upper end of the through hole on the initial processed surface of the object to be processed.
[17] The laser processing method according to any one of [1] to [16], wherein a plurality of the recesses are formed, and a distance between bottoms of the adjacent recesses is set to 110% or less of a width of the bottom.
[18] A method for producing a substrate having the recess and/or the through hole, the method comprising a step of forming the recess and/or the through hole on a substrate being the object to be processed by the laser processing method according to any one of [1] to 17.
[19] A laser processing apparatus for forming a recess and/or a through hole on an object to be processed by using laser, the apparatus comprising: a laser light source configured to oscillate the laser; and an optical system configured to shape an irradiation shape of the laser into an irradiation shape in which an intensity of an outer portion is larger than an intensity of an inner portion in intensity distribution of the laser on a surface to be processed of the object to be processed.
[20] The laser processing apparatus according to [19], wherein the optical system comprises: a prism configured to convert laser having intensity distribution in which a laser intensity at a center is largest and a laser intensity in a base is small into laser having the irradiation shape in which the intensity of the outer portion is larger than the intensity of the inner portion in the intensity distribution of the laser; and a shaping optical system configured to convert the irradiation shape of the laser converted by the prism into a top-hat-shaped irradiation shape.
[21] The laser processing apparatus according to [20], wherein the apparatus comprises a component comprising a roof prism or a conical prism as the prism.
[22] The laser processing apparatus according to any one of [19] to [21], wherein the laser light source comprises an excimer laser oscillator.
[23] The laser processing apparatus according to any one of [19] to [22], further comprising: a stage on which the object to be processed is to be mounted; and a photomask positioned between the optical system and the stage.
[24] The laser processing apparatus according to [23], further comprising a controller configured to synchronously move the object to be processed on the stage and the photomask.
[25] A substrate used for a semiconductor package substrate, wherein the substrate comprises at least two recesses on a front face of the substrate, the recesses being adjacent to each other on a cross section perpendicular to the front face, a distance between bottoms of the recesses on the cross section is 110% or less of a width of the bottom of the recess, a depth of the recess on the cross section is 20 µm or less, and a ratio of the depth of the recess relative to the width of the bottom of the recess on the cross section is 1.0 or more.
[26] The substrate according to [25], wherein the width of the bottom of the recess is 70% or more of an opening width of the recess on the front face.
[27] The substrate according to [26], wherein the opening width of the recess on the front face is 20 µm or less.
[28] The substrate according to any one of [25] to [27], wherein the ratio of the depth of the recess relative to the width of the bottom of the recess on the cross section is 1.1 or more.
[29] The substrate according to any one of [25] to [28], wherein the ratio of the depth of the recess relative to the width of the bottom of the recess is 1.5 or more.
[30] The substrate according to any one of [25] to [29], wherein the ratio of the depth of the recess relative to the width of the bottom of the recess is 2.4 or more.
[31] The substrate according to any one of [25] to [30], wherein the ratio of the depth of the recess relative to the width of the bottom of the recess is 3.4 or more.
[32] The substrate according to [25], wherein the width of the bottom of the recess is 70% or more of the opening width of the recess, and the ratio of the depth of the recess relative to the width of the bottom of the recess is 2.4 or more.
[33] The substrate according to any one of [25] to [32], wherein the recess comprises a trench.
[34] The substrate according to any one of [25] to [32], wherein the substrate has a back face being on an opposite side to the front face, and the substrate further comprises a through hole that goes through from the front face to the back face.
[35] The substrate according to [34], wherein a width of an opening on an upper end of the through hole on the front face is 20 µm or less.
[36] The substrate according to [34] or [35], wherein a ratio of a processing length of the through hole relative to a width of an opening on a lower end of the through hole on the back face is 1.0 or more.
[37] The substrate according to any one of [34] to [36], wherein a width of an opening on a lower end of the through hole on the back face is 70% or more of a width of an opening on an upper end of the through hole on the front face.
[38] The substrate according to [34] or [35], wherein a ratio of a processing length of the through hole relative to a width of an opening on a lower end of the through hole on the back face is 1.0 or more, and a width of the opening on the lower end of the through hole is 70% or more of a width of an opening on an upper end of the through hole on the front face.
[39] The substrate according to [34], wherein a width of the bottom of the recess is 70% or more of the opening width of the recess, a ratio of a depth of the recess relative to a width of the bottom of the recess is 2.4 or more, a ratio of a processing length of the through hole relative to a width of an opening on a lower end of the through hole on the back face is 1.0 or more, and the width of the opening on the lower end of the through hole is 70% or more of a width of an opening on an upper end of the through hole on the front face.
[40] A semiconductor package substrate, comprising the substrate according to any one of [25] to [39], wherein metal wiring is embedded in the recess.
[41] A substrate used for a semiconductor package substrate, comprising a through hole that goes through from a front face of the substrate to a back face being an opposite side to the front surface, wherein a width of an opening on a lower end of the through hole on the back face is 70% or more of a width of an opening on an upper end of the through hole on the front face.
[42] The substrate according to [41], wherein the width of the opening on the upper end of the through hole on the front face is 20 µm or less.
[43] The substrate according to [41] or [42], wherein a ratio of a processing length of the through hole relative to the width of the opening on the lower end of the through hole on the back face is 1.0 or more.
[44] A semiconductor package substrate, comprising the substrate according to any one of [34] to [39] and [41] to [43], wherein the through hole has been subjected to a VIA processing.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A laser processing method for forming a recess and/or a through hole on an object to be processed using laser, wherein
processing is performed with an irradiation shape in which intensity distribution of the laser on a surface to be processed of the object to be processed is set such that an intensity of an outer portion is larger than an intensity of an inner portion in the intensity distribution.

2. The laser processing method according to claim 1, wherein processing is performed while changing the shape of the intensity distribution of the laser on the surface to be processed of the object to be processed as the processing proceeds in a depth direction of the object to be processed.

3. The laser processing method according to claim 2, wherein processing is performed while changing the shape of the intensity distribution of the laser so that the intensity of the outer portion is larger than the intensity of the inner portion in the intensity distribution of the laser as the processing proceeds in the depth direction of the object to be processed.

4. The laser processing method according to claim 3, wherein processing is performed while changing the shape of the intensity distribution of the laser so that the intensity of the outer portion is larger than the intensity of the inner portion in the intensity distribution of the laser as the processing proceeds in the depth direction of the object to be processed by passing laser having intensity distribution in which a laser intensity at a center is largest and a laser intensity in a base is small through a prism.

5. The laser processing method according to claim 4, wherein a component comprising a roof prism or a conical prism is used as the prism.

6. A laser processing method for forming a recess and/or a through hole on an object to be processed using laser, wherein
an optical system is used, the optical system is configured to shape an irradiation shape of the laser in which an intensity of an outer portion is larger than an intensity of an inner portion in intensity distribution of the laser into a top-hat-shaped irradiation shape.

7. The laser processing method according to claim 6, wherein
an initial surface to be processed of the object to be processed is processed with laser having the top-hat-shaped irradiation shape, and
at least a part of the object to be processed except for the initial surface to be processed is processed with laser having the irradiation shape in which the intensity of the outer portion is larger than the intensity of the inner portion.

8. The laser processing method according to any one of claims 1 to 7, wherein a substrate for a semiconductor package is processed as the object to be processed to form a recess and/or a through hole on the substrate for a semiconductor package.

9. The laser processing method according to any one of claims 1 to 7, wherein the laser is oscillated by using an excimer laser oscillator.

10. The laser processing method according to any one of claims 1 to 7, wherein the object to be processed is irradiated with the laser through a photomask.

11. The laser processing method according to any one of claims 1 to 7, wherein processing is performed while relatively scanning the laser relative to the surface to be processed.

12. The laser processing method according to any one of claims 1 to 7, wherein ablation processing is performed.

13. The laser processing method according to any one of claims 1 to 7, wherein the recess and/or the through hole having a width of 20 µm or less is formed.

14. The laser processing method according to claim 13, wherein the recess and/or the through hole having a depth of 20 µm or less is formed.

15. The laser processing method according to any one of claims 1 to 7, wherein, as the recess and/or the through hole, a recess and/or a through hole in which a ratio of a height of processed portion relative to a width of a bottom of the recess or to a width of an opening on a lower end of the through hole is 1.0 or more is formed.

16. The laser processing method according to any one of claims 1 to 7, wherein
the recess is formed in which a width of a bottom of the recess is 70% or more of an opening width of the recess on an initial processed surface of the object to be processed, and/or
the through hole is formed in which a width of an opening on a lower end of the through hole is 70% or more of a width of an opening on an upper end of the through hole on the initial processed surface of the object to be processed.

17. The laser processing method according to any one of claims 1 to 7, wherein a plurality of the recesses are formed, and a distance between bottoms of the adjacent recesses is set to 110% or less of a width of the bottom.

18. A method for producing a substrate having the recess and/or the through hole, the method comprising a step of forming the recess and/or the through hole on a substrate being the object to be processed by the laser processing method according to any one of claims 1 to 7.

19. A laser processing apparatus for forming a recess and/or a through hole on an object to be processed by using laser, the apparatus comprising:
a laser light source configured to oscillate the laser; and
an optical system configured to shape an irradiation shape of the laser into an irradiation shape in which an intensity of an outer portion is larger than an intensity of an inner portion in intensity distribution of the laser on a surface to be processed of the object to be processed.

20. The laser processing apparatus according to claim 19, wherein the optical system comprises:
a prism configured to convert laser having intensity distribution in which a laser intensity at a center is largest and a laser intensity in a base is small into laser having the irradiation shape in which the intensity of the outer portion is larger than the intensity of the inner portion in the intensity distribution of the laser; and
a shaping optical system configured to convert the irradiation shape of the laser converted by the prism into a top-hat-shaped irradiation shape.

21. The laser processing apparatus according to claim 20, wherein the apparatus comprises a component comprising a roof prism or a conical prism as the prism.

22. The laser processing apparatus according to any one of claims 19 to 21, wherein the laser light source comprises an excimer laser oscillator.

23. The laser processing apparatus according to any one of claims 19 to 21, further comprising:
a stage on which the object to be processed is to be mounted; and
a photomask positioned between the optical system and the stage.

24. The laser processing apparatus according to claim 23, further comprising a controller configured to synchronously move the object to be processed on the stage and the photomask.

25. A substrate used for a semiconductor package substrate, wherein
the substrate comprises at least two recesses on a front face of the substrate, the recesses being adjacent to each other on a cross section perpendicular to the front face,
a distance between bottoms of the recesses on the cross section is 110% or less of a width of the bottom of the recess,
a depth of the recess on the cross section is 20 µm or less, and
a ratio of the depth of the recess relative to the width of the bottom of the recess on the cross section is 1.0 or more.

26. The substrate according to claim 25, wherein the width of the bottom of the recess is 70% or more of an opening width of the recess on the front face.

27. The substrate according to claim 26, wherein the opening width of the recess on the front face is 20 µm or less.

28. The substrate according to claim 25, wherein the ratio of the depth of the recess relative to the width of the bottom of the recess on the cross section is 1.1 or more.

29. The substrate according to claim 25, wherein the ratio of the depth of the recess relative to the width of the bottom of the recess is 1.5 or more.

30. The substrate according to claim 25, wherein the ratio of the depth of the recess relative to the width of the bottom of the recess is 2.4 or more.

31. The substrate according to claim 25, wherein the ratio of the depth of the recess relative to the width of the bottom of the recess is 3.4 or more.

32. The substrate according to claim 25, wherein
the width of the bottom of the recess is 70% or more of the opening width of the recess, and
the ratio of the depth of the recess relative to the width of the bottom of the recess is 2.4 or more.

33. The substrate according to claim 25, wherein the recess comprises a trench.

34. The substrate according to claim 25, wherein
the substrate has a back face being on an opposite side to the front face, and
the substrate further comprises a through hole that goes through from the front face to the back face.

35. The substrate according to claim 34, wherein a width of an opening on an upper end of the through hole on the front face is 20 µm or less.

36. The substrate according to claim 34, wherein a ratio of a processing length of the through hole relative to a width of an opening on a lower end of the through hole on the back face is 1.0 or more.

37. The substrate according to claim 34, wherein a width of an opening on a lower end of the through hole on the back face is 70% or more of a width of an opening on an upper end of the through hole on the front face.

38. The substrate according to claim 34, wherein
a ratio of a processing length of the through hole relative to a width of an opening on a lower end of the through hole on the back face is 1.0 or more, and
a width of the opening on the lower end of the through hole is 70% or more of a width of an opening on an upper end of the through hole on the front face.

39. The substrate according to claim 34, wherein
a width of the bottom of the recess is 70% or more of the opening width of the recess,
a ratio of a depth of the recess relative to a width of the bottom of the recess is 2.4 or more,
a ratio of a processing length of the through hole relative to a width of an opening on a lower end of the through hole on the back face is 1.0 or more, and
the width of the opening on the lower end of the through hole is 70% or more of a width of an opening on an upper end of the through hole on the front face.

40. A semiconductor package substrate, comprising the substrate according to any one of claims 25 to 39, wherein metal wiring is embedded in the recess.

41. A substrate used for a semiconductor package substrate, comprising a through hole that goes through from a front face of the substrate to a back face being an opposite side to the front surface, wherein
a width of an opening on a lower end of the through hole on the back face is 70% or more of a width of an opening on an upper end of the through hole on the front face.

42. The substrate according to claim 41, wherein the width of the opening on the upper end of the through hole on the front face is 20 µm or less.

43. The substrate according to claim 41, wherein a ratio of a processing length of the through hole relative to the width of the opening on the lower end of the through hole on the back face is 1.0 or more.

44. A semiconductor package substrate, comprising the substrate according to any one of claims 34 to 39 and 41 to 43, wherein the through hole has been subjected to a VIA processing.
